# DEMANDE DE BREVET EUROPEEN

(11) **EP 1 408 613 A1**
(43) Date de publication de la demande: **14.04.2004**
(21) Numéro de dépôt: 03354077.4
(22) Date de dépôt: 07.10.2003
(51) Int. Cl.: H03K 17/082

(54) **Protection d'un interrupteur en alternatif**

(30) Priorité: 07.10.2002 FR 0212428
(71) Demandeur: STMicroelectronics S.A., 92120 Montrouge (FR)
(72) Inventeur: Gonthier, Laurent, 37000 Tours (FR); Peron, Benoît, 37000 Tours (FR)
(74) Mandataire: de Beaumont, Michel

(57) **Abrégé**

L'invention concerne un circuit de détection (25) d'un surcourant dans un élément (22) traversé par un courant alternatif d'alimentation, comportant : un premier comparateur (37), affecté aux alternances d'un premier signe de l'alimentation alternative, recevant sur une entrée de référence (40) une première tension de référence fixant un premier desdits seuils ; un second comparateur (39), affecté aux alternances d'un deuxième signe de l'alimentation alternative, recevant sur une entrée de référence (43) une deuxième tension de référence fixant un deuxième desdits seuils ; et un étage d'entrée fournissant, à des entrées de lecture (36, 38) respectives des comparateurs interconnectées, une tension proportionnelle à ladite tension aux bornes dudit élément, ledit étage comprenant au moins un premier élément résistif (30) introduisant une chute de tension entre une première (A) des bornes de l'élément et lesdites entrées de lecture.

## Description

La présente invention concerne, de façon générale, la protection d'interrupteurs. Plus particulièrement, la présente invention concerne la protection d'un interrupteur bidirectionnel lors de l'apparition d'un surcourant, provenant par exemple d'un court-circuit dans une charge commandée en alternatif par l'interrupteur.

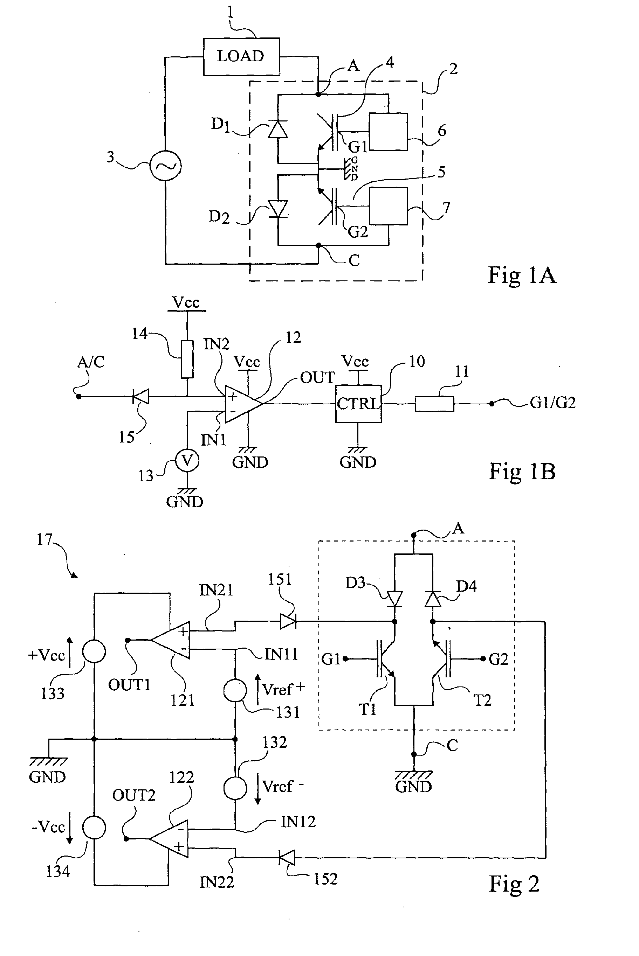

Les figures 1A et 1B illustrent un procédé connu de protection d'un interrupteur bidirectionnel de commande d'une charge alternative contre des surcourants.

La figure 1A illustre, schématiquement et partiellement, une charge (LOAD) 1 connectée en série avec un interrupteur bidirectionnel 2 aux bornes d'une source de tension alternative 3. L'interrupteur bidirectionnel 2 est constitué par l'association en anti-série, entre deux bornes A et C, de deux transistors bipolaires à grille isolée (IGBT) 4 et 5. Par "anti-série", on entend que les transistors IGBT 4 et 5 sont en série et que le point milieu de la série est un point commun d' émetteur. Chaque borne A et C est alors connectée au collecteur d'un des transistors 4 et 5. Par souci de clarté, on désigne dans la suite de la description de la figure 1 par "A" le collecteur du transistor 4 et par "C" le collecteur du transistor 5. L'émetteur de chacun des transistors 4 et 5 est connecté à son collecteur respectif A, C par une diode respective D1, D2. Chaque diode D1, D2 est en antiparallèle avec la jonction de son transistor associé 4, 5. Le collecteur A du transistor 4 est relié à une borne d'alimentation de la charge 1. Le collecteur C du transistor 5 est relié à une borne de la source 3, non connectée à la charge 1. Un circuit de commande et de protection 6 du transistor 4 est connecté entre sa grille G1 et son collecteur A. De même, pour le transistor 5, un autre circuit de commande et de protection 7 est connecté entre sa grille G2 et son collecteur C. Les deux circuits de protection 6 et 7 sont identiques.

La figure 1B illustre, schématiquement et partiellement, un circuit de protection (6 ou 7, figure 1A) connecté entre un collecteur A ou C et une grille G1 ou G2. Un bloc de commande (CTRL) 10 comporte deux bornes d'alimentation connectées respectivement à un rail d'alimentation haute Vcc et un rail d'alimentation basse ou masse GND relié à l'émetteur du transistor protégé 4 ou 5. Une borne de sortie du bloc 10 est reliée à une extrémité d'une résistance 11 dont une autre extrémité constitue la borne de sortie du circuit de protection 6, respectivement 7, reliée à la grille G1, respectivement G2, du transistor 4, respectivement 5. Une borne d'entrée du bloc 10 est connectée à une borne de sortie OUT d'un comparateur 12. Deux bornes d'alimentation du comparateur 12 sont reliées respectivement aux rails d'alimentation haute Vcc et basse GND. Une entrée inverseuse IN1 du comparateur 12 est reliée à une source de tension continue de référence (V) 13. Une entrée non-inverseuse IN2 du comparateur 12 est reliée au rail d'alimentation haute Vcc, par l'intermédiaire d'une résistance de polarisation 14. L'entrée non-inverseuse IN2 est également reliée à l'anode d'une diode 15 dont la cathode est reliée au collecteur A, respectivement C, du commutateur unidirectionnel protégé 4, respectivement 5. Les circuits 6, respectivement 7, assurent leur fonction de protection en commandant la grille G1, respectivement G2, du transistor 4, respectivement 5, en fonction du résultat de la comparaison, par le comparateur 12, de la valeur courante de la tension collecteur-émetteur à la référence de tension V fournie par la source 13.

Le circuit de protection de la figure 1B permet de contrôler la tension collecteur-émetteur Vce aux bornes du transistor protégé 4 ou 5 au moyen du comparateur 12. Compte tenu de la caractéristique courant tension d'un transistor, une tension Vce anormalement élevée par rapport à la référence fixée par la source 13 correspond à l'apparition d'un surcourant, lié à un dysfonctionnement de la charge 1 ou de la source 3. La diode 15 est une diode de protection destinée à protéger l'entrée non-inverseuse (+) IN2 du comparateur 12, notamment lorsque le transistor protégé 4 ou 5 est bloqué.

Un inconvénient de la structure décrite précédemment en relation avec les figures 1A et 1B réside dans la nécessité de répéter deux fois un circuit de protection d'un commutateur unidirectionnel pour obtenir un circuit de protection d'un commutateur bidirectionnel.

Un autre inconvénient de la structure précédente réside en ce que les diodes de protection 15 des circuits 6, 7 doivent pouvoir tenir une tension élevée, notamment lorsque l'interrupteur 2 est ouvert. Les diodes haute tension sont relativement complexes et encombrantes à former sous forme intégrée.

On a considéré précédemment que le commutateur bidirectionnel 2 est constitué de l'association en anti-série de deux transistors IGBT, chacun étant associé à une diode de roue libre en anti-parallèle. Toutefois, les mêmes inconvénients sont rencontrés si les transistors sont de type MOS.

La figure 2 illustre, schématiquement et partiellement, un autre mode de réalisation connu dans lequel le commutateur bidirectionnel 2 est constitué de l'association en antiparallèle de deux transistors IGBT ou MOS de même type de conduction T1 et T2, chaque transistor T1, T2 étant en série avec une diode de redressement respective D3, D4. Par souci de clarté, la connexion de l'interrupteur 2 en série avec la charge (LOAD) 1 aux bornes de la source alternative 3 décrite en relation avec la figure 1A est indiquée uniquement par la mention des bornes A et C en figure 2. La borne A est connectée à l'anode de la diode D3 dont la cathode est reliée au collecteur du transistor T1. La borne A est également connectée à la cathode de la diode D4 dont l'anode est reliée à l'émetteur du transistor T2. La borne C est connectée à l'émetteur du transistor T1 et au collecteur du transistor T2.

Le circuit de protection 17 de l'interrupteur 2 comporte ici deux comparateurs distincts 121 et 122. L'entrée non-inverseuse (+) IN21 du comparateur 121 est connectée à l'anode d'une diode 151 dont la cathode est connectée au collecteur du transistor T1 (cathode de la diode D3 ) . L'entrée inverseuse (-) IN11 du comparateur 121 reçoit une tension de référence Vref+, positive par rapport à la masse définie par une des deux bornes de l'interrupteur 2, par exemple la borne C, et fournie par une source de tension 131.

L'entrée non-inverseuse (+) IN22 du comparateur 122 est connectée à la cathode d'une diode 152 dont l'anode est connectée à l'émetteur du transistor T2 (anode de la diode D4). L'entrée inverseuse (-) IN12 du comparateur 121 reçoit une tension de référence Vref-, négative par rapport à la masse GND et fournie par une seconde source de tension 132.

Les sorties respectives OUT1 et OUT2 des comparateurs 121, 122 sont reliées à des bornes d'entrée d'un circuit de commande (non représenté) pilotant, généralement par l'intermédiaire de résistances (non représentées), les grilles G1 et G2 des transistors T1 et T2.

L'alimentation du comparateur 121 est assurée par une source 133 d'une tension d'alimentation positive +Vcc connectée entre une borne d'alimentation du comparateur 121 et la masse GND. De façon similaire, une source 134 d'une tension d'alimentation négative -Vcc est connectée entre une borne d'alimentation du comparateur 122 et la masse GND.

Le principe de fonctionnement du circuit de protection 17 de la figure 2 est similaire à celui d'un circuit de protection 6, 7 des figures 1A et 1B, la tension Vce de chaque transistor étant comparée à une référence respective Vref+, Vref- fixée par la source respective 131 ou 132. La diode 151, 152 de chaque partie du circuit 17 dédiée à la protection de l'un de deux commutateurs unidirectionnels en courant T1, D3 et T2, D4 est homologue à la diode 15 de chaque circuit 6, 7 de la figure 1.

Un inconvénient d'une telle structure réside dans la nécessité de prévoir deux sources d'alimentation de référence de tension 133 et 134.

Un autre inconvénient d'une telle structure réside dans la présence des diodes haute tension 151 et 152.

Selon un autre procédé connu, une résistance de lecture est introduite en série avec la charge et l'interrupteur bidirectionnel et on détecte, aux bornes de cette résistance, l'apparition de surcourants. Par rapport au schéma de la figure 2, les deux entrées non-inverseuses des comparateurs 121 et 122 sont alors reliées au point milieu entre l'interrupteur et la résistance de détection, l'autre borne de cette résistance étant reliée à la masse qui correspond à une des bornes d'application de la tension alternative. Les diodes 151 et 152 ne sont alors plus nécessaires.

Un objet de la présente invention est de proposer un circuit de protection d'un commutateur bidirectionnel qui pallie les inconvénients des circuits classiques et qui notamment soit plus facilement intégrable.

La présente invention vise également à proposer un tel circuit tel qu'il n'utilise pas d'alimentation indépendante négative.

La présente invention vise également à proposer un tel circuit qui soit commun aux deux commutateurs unidirectionnels le constituant.

Pour atteindre ces objets et d'autres, la présente invention prévoit un circuit de détection d'un surcourant dans un élément traversé par un courant alternatif d'alimentation, consistant à détecter une variation de la tension aux bornes de l'élément hors de deux seuils prédéterminés, ledit circuit comportant :
un premier comparateur, affecté aux alternances d'un premier signe de l'alimentation alternative, recevant sur une entrée de référence une première tension de référence fixant un premier desdits seuils ;
un second comparateur, affecté aux alternances d'un deuxième signe de l'alimentation alternative, recevant sur une entrée de référence une deuxième tension de référence fixant un deuxième desdits seuils ; et
un étage d'entrée fournissant, à des entrées de lecture respectives des comparateurs interconnectées, une tension proportionnelle à ladite tension aux bornes dudit élément, ledit étage comprenant au moins un premier élément résistif introduisant une chute de tension entre une première des bornes de l'élément et lesdites entrées de lecture.

Selon un mode de réalisation de la présente invention, le circuit est alimenté entre un rail d'alimentation haut et une masse à laquelle est connectée une desdites bornes de l'élément non connectée audit premier élément résistif.

Selon un mode de réalisation de la présente invention, l'étage d'entrée comporte :
une première association en série de deux diodes basse tension, entre ledit rail haut et la masse, l'anode d'une première diode étant connectée à la masse alors que la cathode d'une seconde diode est connectée au rail haut ; et
une deuxième association en série, entre ledit rail haut et ladite masse, d'au moins deux éléments résistifs, les points milieu desdites première et deuxième associations en série étant interconnectés auxdites entrées de lecture desdits premier et second comparateurs.

Selon un mode de réalisation de la présente invention, lesdites première et seconde tensions de référence sont fixées par au moins un pont diviseur résistif réalisé entre ledit rail haut et la masse.

Selon un mode de réalisation de la présente invention, lesdites première et seconde tensions de référence sont fixées par un seul pont diviseur résistif constitué par une connexion en série, entre ledit rail haut et ladite masse, de trois éléments résistifs, lesdits seuils prédéterminés étant respectivement prélevés aux bornes de la résistance intermédiaire du pont.

Selon un mode de réalisation de la présente invention, des sorties des premier et second comparateurs sont combinées.

Selon un mode de réalisation de la présente invention, les sorties sont combinées par une porte logique OU à deux entrées.

Selon un mode de réalisation de la présente invention, l'élément traversé par un courant alternatif d'alimentation est un interrupteur bidirectionnel.

Selon un mode de réalisation de la présente invention, l'élément traversé par un courant alternatif d'alimentation est une résistance.

L'invention prévoit également un circuit de protection contre un surcourant d'un interrupteur bidirectionnel à l'état fermé, traversé par un courant alternatif d'alimentation.

Selon un mode de réalisation de la présente invention, ladite résistance est en série avec ledit interrupteur.

Ces objets, caractéristiques et avantages, ainsi que d'autres de la présente invention seront exposés en détail dans la description suivante de modes de réalisation particuliers faite à titre non-limitatif en relation avec les figures jointes parmi lesquelles :
les figures 1A et 1B, qui ont été décrites précédemment, illustrent un premier mode classique de protection d'un interrupteur contre des surcourants ;
la figure 2, qui a été décrite précédemment, illustre un autre mode classique de protection d'un interrupteur contre des surcourants ;
la figure 3 illustre, schématiquement et partiellement, un mode de réalisation de la protection d'un interrupteur bidirectionnel de commande d'une charge alternative contre des surcourants selon la présente invention ; et
la figure 4 illustre, schématiquement et partiellement, un autre mode de réalisation de la protection d'un interrupteur bidirectionnel de commande d'une charge alternative contre des surcourants selon la présente invention.

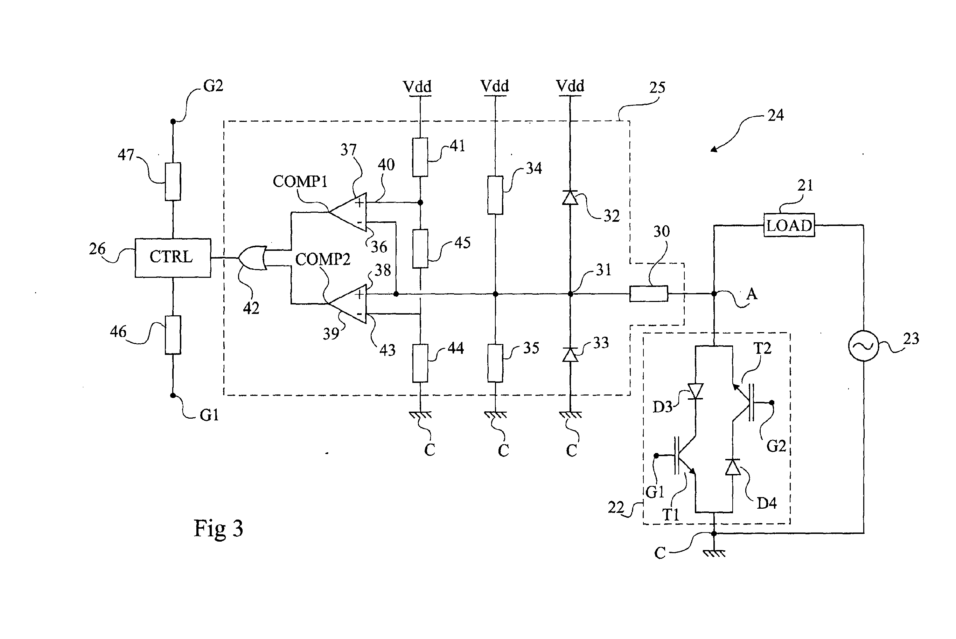

La figure 3 illustre, schématiquement et partiellement, un mode de réalisation de la présente invention. Une charge (LOAD) 21 est connectée en série avec un interrupteur bidirectionnel 22 aux bornes d'une source de tension alternative 23. L'interrupteur bidirectionnel 22 est un interrupteur à deux bornes d'entrée/sortie A et C et deux bornes de commande G1 et G2. Par exemple, la borne A est reliée à une borne d'alimentation de la charge 21, la borne C est connectée à une borne de la source 23 dont une autre borne est connectée à une autre borne d'alimentation de la charge 21. Ci-après, la borne C constitue le point de référence basse de tension ou masse. La structure de l'interrupteur 22 peut être identique à celle de l'interrupteur 2 de la figure 1A.

Selon le mode de réalisation illustré en figure 3, l'interrupteur 22 est constitué par l'association en anti-parallèle de deux commutateurs unidirectionnels en courant. Chaque commutateur unidirectionnel est constitué de l'association en série, entre les bornes A et C, d'une diode D3, D4 et d'un transistor T1, T2.

La connexion en série dans chaque branche de l'interrupteur 22 d'un transistor T1, T2 avec une diode respective D3, D4 peut être similaire à celle de la figure 2.

Selon un mode de réalisation préféré illustré en figure 3, chaque collecteur d'un transistor T1, T2 est relié à la cathode de sa diode de redressement respective D3, D4.

Les transistors T1, T2 des deux commutateurs unidirectionnels sont des transistors MOS de même type de conduction ou, par exemple, des transistors bipolaires à grille isolée (IGBT).

Selon la présente invention, l'interrupteur 22 est protégé contre les surcourants par un circuit de protection unique 24 à deux bornes d'entrée, respectivement connectées aux bornes A et C, et deux bornes de sortie, respectivement connectées, de préférence par l'intermédiaire d'une résistance de protection respective 46, 47, aux bornes de commande G1 et G2 de l'interrupteur 22. Plus particulièrement, le circuit 24 comprend un circuit de détection 25 et un circuit de commande (CTRL) 26.

Selon la présente invention, le circuit de détection 25 comprend une résistance 30 dont une extrémité constitue l'entrée du circuit de protection 24 connectée à la borne A. Une autre extrémité de la résistance 30 est reliée au point milieu 31 d'une association série, entre un rail d'alimentation haute Vdd et la masse, de deux diodes basse tension 32 et 33. L'anode de la diode 33 est connectée à la masse alors que la cathode de la diode 32 est connectée au rail Vdd.

Le point milieu 31 est relié au point milieu d'une association en série, également entre le rail haut Vdd et la masse, de deux résistances 34 et 35. Le point milieu 31 est également connecté, d'une part, à une entrée de lecture inverseuse (-) 36 d'un premier comparateur 37 et, d'autre part, à une entrée de lecture non-inverseuse (+) 38 d'un second comparateur 39.

Une entrée non-inverseuse (+) 40 du comparateur 37 constitue une entrée de référence connectée, par l'intermédiaire d'une résistance 41, au rail haut Vdd. La sortie COMP1 du comparateur 37 est connectée à une première de deux entrées d'une porte OU 42. Une entrée inverseuse (-) 43 du comparateur 39 constitue une entrée de référence connectée, par l'intermédiaire d'une résistance 44, à la masse. La sortie COMP2 du second comparateur 39 est connectée à une seconde entrée de la porte 42.

De préférence, une résistance intermédiaire 45 est connectée entre l'entrée non-inverseuse (+) 40 du premier comparateur 37 et l'entrée inverseuse (-) 43 du second comparateur 39. Les valeurs des résistances 41, 44 et 45 des entrées de référence 40, 43 sont ajustées de telle sorte que le seuil haut du premier comparateur 37 est supérieur au seuil bas du second comparateur 39. En variante, les résistances en série 41, 44 et 45 peuvent être remplacées par deux diviseurs de tension résistifs respectivement affectés aux entrées 40 et 43 des comparateurs 37 et 39. Un avantage du mode de réalisation de la figure 3 est toutefois de lier entre eux les seuils de la plage de fonctionnement de sorte qu'ils subissent les mêmes éventuelles dérives, la résistance 45 garantissant l'écart entre les seuils.

La sortie de la porte 42 constitue la sortie du circuit de détection 25 et est reliée à une entrée du circuit de commande 26.

Par souci de simplification et de clarté, comme le comprendra l'homme de l'art, on a omis de représenter en figure 3 les alimentations Vcc des comparateurs 37 et 39 ainsi que du circuit de commande 26.

En fonctionnement normal, la charge 21 étant parcourue par un courant alternatif prédéterminé par sa nature et/ou son mode de fonctionnement, la tension alternative aux bornes A et C de l'interrupteur 22 fermé est très faible (due à la résistance série de l'interrupteur 22 à l'état passant) par rapport à la tension alternative fournie par la source 23. Les valeurs des différentes résistances d'entrée 30, 34 et 35 sont fixées pour que le signal de tension appliqué sur les entrées de lecture inverseuse 36 et non-inverseuse 38 des premier 37 et second 39 comparateurs, respectivement reste dans une plage de tension entre les seuils fixés par les résistances 41, 44 et 45. Alors, le signal de tension transmis par la résistance d'entrée 30 est tel que, pour les deux comparateurs 37 et 39, le signal basse tension sur leur entrée non-inverseuse est toujours (en fonctionnement normal) supérieur au signal basse tension sur leur entrée inverseuse. Les sorties COMP1 et COMP2 prennent alors un même état logique. Le circuit de détection 25 fournit donc au circuit de commande 26 un signal d'une première valeur logique. Le circuit de commande 26 est conçu pour assurer, en réponse à cette première valeur logique, le maintien fermé de l'interrupteur 22.

Lors de l'apparition d'un surcourant, généralement lié à un dysfonctionnement de la charge 21 ou de la source 23, dès que l'image de la tension aux bornes A, C de l'interrupteur 22 sort de la plage de tension acceptable fixée par les seuils des comparateurs 37 et 39 et un coefficient d' atténuation lié à la présence des résistances 30, 34 et 35, l'un des comparateurs 37 et 39 change d'état. Cette image basse tension est obtenue grâce à l'arrangement de l'étage d'entrée constitué par les résistances 30, 34 et 35 et les diodes 32 et 33 qui servent à limiter la tension au point milieu 31 dans une plage allant de Vdd+VD32 à GND-VD33, lorsque l'interrupteur 22 est bloqué, VD32 et VD33 étant la chute de tension introduite par la diode respective 32 et 33. Dans le cas d'une alternance positive, la détection est opérée en cas de dépassement (au-dessus) du seuil haut de l'entrée de référence (+) 40. Dans le cas d'une alternance négative, la détection est opérée en cas de dépassement (au-dessous) du seuil bas de l'entrée de référence (-) 43. La commutation correspondante d'une seule entrée de la porte 42 provoque une commutation de la sortie de cette porte. Le circuit de commande 26 reçoit alors une seconde valeur logique complémentaire de la première. Le circuit de commande 26 est conçu pour modifier, en réponse à cette seconde valeur logique, la commande des grilles G1 et G2 de façon à provoquer l'ouverture de l'interrupteur 22.

Un avantage de la présente invention est de proposer un circuit de protection contre des surcourants d'un interrupteur bidirectionnel commandant une charge alternative plus facile à intégrer que les circuits connus. En effet, le circuit de détection selon l'invention, au contraire des circuits connus, n'utilise aucune alimentation supplémentaire négative.

En outre, un seul et même circuit connecté aux bornes de l'ensemble d'un interrupteur bidirectionnel permet avantageusement de protéger deux commutateurs unidirectionnels commandables le constituant.

Un autre avantage de la présente invention, réside en ce que les circuits de détection et de protection selon l'invention sont avantageusement utilisables tant avec des commutateurs de type anti-parallèle qu'avec des commutateurs de type anti-série. Pour un montage en anti-série, on doit toutefois utiliser un shunt (par exemple, une résistance) entre les deux interrupteurs.

En outre, le circuit de détection selon l'invention peut avantageusement être utilisé avec un commutateur bidirectionnel dit de type MBS qui présente la structure anti-parallèle de la figure, dans laquelle la cathode de la diode D3, D4 est connectée au collecteur du transistor associé T1 et T2. Au contraire, le circuit de détection et de protection connu de la figure 2 ne pouvait pas être utilisé avec un tel commutateur bidirectionnel MBS. En effet, pour le circuit de protection 17 de la figure 2, il faut que la borne d'entrée IN22 du comparateur 122 soit connectée à l'émetteur du transistor T2. Dans le cas d'un commutateur bidirectionnel MBS, une telle connexion conduit à connecter directement la borne A et l'anode de la diode 152. Comme l'illustre la figure 2, il faut protéger l'entrée IN22 en interposant la diode D4 entre la borne A et l'anode de la diode 152. Ceci est doublement avantageux, d'une part en ce que le circuit selon l'invention peut être utilisé avec plus de commutateurs que ceux de l'état de l'art. D'autre part, les commutateurs de type MBS sont plus faciles à réaliser en termes d'intégration.

Les valeurs des différentes résistances 30, 34, 35, 41, 44 et 45 sont fixées, d'une part, de façon à permettre la détection d'un surcourant selon les principes exposés précédemment. D'autre part, les valeurs des résistances 30, 34 et 35, sont également fixées de façon à limiter, lorsque l'interrupteur 22 est ouvert, le courant de fuite en parallèle de l'interrupteur 22 ainsi que la puissance dissipée dans ces résistances 30, 34, 35, 41, 44 et 45.

A titre d'exemple particulier de réalisation, on pourra fixer pour les résistances les valeurs suivantes :
résistance 30 : 1.10⁶ Ω ;
résistance 34 : 1,3.10⁶ Ω ;
résistance 35 : 360.10³ Ω ;
résistance 41 : 47.10³ Ω ;
résistance 44 : 4,3.10³ Ω ; et
résistance 45 : 13.10³ Ω.

Dans ce cas, pour une tension alternative fournie par la source 23 de 220 V, les seuils des comparateurs 37 et 39 sont de l'ordre de 4 volts et 1 volt, respectivement, ce qui permet de détecter l'apparition d'un surcourant dès que la tension collecteur-émetteur Vce aux bornes d'un transistor T1 ou T2 dépasse, en valeur absolue, 7 volts.

Par ailleurs, les diodes 32 et 33 sont des diodes basse tension. Elles sont donc plus faciles à réaliser et moins encombrantes sous forme intégrée que les diodes homologues (15, figure 1B) haute tension des circuits connus. En effet, les diodes selon l'invention sont connectées à l'alimentation basse tension Vdd. Au contraire des diodes de protection des circuits connus, elles ne sont pas destinées à protéger les circuits de protection lorsque l'interrupteur est ouvert, c'est-à-dire que la tension à ses bornes est élevée. En outre, lors de l'apparition d'un surcourant, les diodes 32 et 33 sont protégées en courant par la résistance d'entrée 30.

Comme le comprendra l'homme de l'art, le circuit de détection selon la présente invention n'est pas limité à une détection d'un surcourant aux bornes d'un interrupteur bidirectionnel.

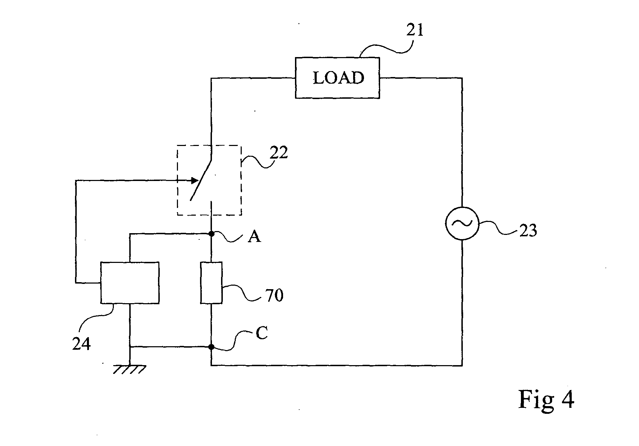

Ainsi, la figure 4 illustre, schématiquement et partiellement, un autre mode de réalisation de la protection d'un interrupteur 22 bidirectionnel de commande d'une charge alternative 21 alimenté par une source alternative 23. Ce mode de réalisation diffère de celui de la figure 3 en ce que le circuit de protection 24 selon l'invention est maintenant connectée aux bornes d'une résistance 70 connectée en série avec l'interrupteur 22 et la charge 21 aux bornes de la source 23. La masse indiquée en figure 4 comme correspondant à la borne C peut toutefois, en variante, correspondre à la borne A.

Bien entendu, la présente invention est susceptible de diverses variantes et modifications qui apparaîtront à l'homme de l'art. En particulier, on a décrit précédemment l'invention appliquée à un interrupteur bidirectionnel particulier. Toutefois, l'invention s'applique également à un interrupteur bidirectionnel constitué de l'association en anti-série de deux commutateurs unidirectionnels en courant commandables connectés en anti-parallèle à des diodes de roue libre respectives. En outre, on a considéré dans la description précédente que les commutateurs unidirectionnels sont des transistors IGBT. Les commutateurs unidirectionnels peuvent toutefois être des transistors MOS à canal N ou P, associés en série ou en anti-parallèle. En outre, des éléments particuliers du circuit peuvent être remplacés par des éléments fonctionnellement équivalent. En particulier, l'homme de l'art saura choisir un circuit de commande 26 propre à réaliser un pilotage approprié des bornes de commande de l'interrupteur 22. De façon similaire, la fonction de comparaison décrite en relation avec les comparateurs 37 et 39 peut être réalisée par tout circuit approprié.

Par ailleurs, on a considéré dans la description de l'invention que l'interrupteur commande l'alimentation d'une charge placée en série avec l'interrupteur. Toutefois, l'interrupteur pourrait être placé en parallèle avec la charge et commander son alimentation court-circuitant selon un cycle prédéterminé, par exemple en fonction de la tension à ses bornes.

De plus, la charge (LOAD) 21 peut être une quelconque charge bidirectionnelle alimentée en alternatif. En particulier, la charge peut notamment être un élément résistif, par exemple dans des dispositifs d'éclairage ou de chauffage.

## Revendications

1. Circuit de détection (25) d'un surcourant dans un élément (22 ; 70) traversé par un courant alternatif d'alimentation, consistant à détecter une variation de la tension aux bornes (A, C) de l'élément hors de deux seuils prédéterminés, **caractérisé en ce qu'**il comporte :
un premier comparateur (37), affecté aux alternances d'un premier signe de l'alimentation alternative, recevant sur une entrée de référence (40) une première tension de référence fixant un premier desdits seuils ;
un second comparateur (39), affecté aux alternances d'un deuxième signe de l'alimentation alternative, recevant sur une entrée de référence (43) une deuxième tension de référence fixant un deuxième desdits seuils ; et
un étage d'entrée fournissant, à des entrées de lecture (36, 38) respectives des comparateurs interconnectées, une tension proportionnelle à ladite tension aux bornes dudit élément, ledit étage comprenant au moins un premier élément résistif (30) introduisant une chute de tension entre une première (A) des bornes de l'élément et lesdites entrées de lecture.

2. Circuit de détection (25) selon la revendication 1, **caractérisé en ce qu'**il est alimenté entre un rail d'alimentation haut (Vdd) et une masse à laquelle est connectée une (C) desdites bornes de l'élément (22 ; 70) non connectée audit premier élément résistif (30).

3. Circuit de détection (25) selon la revendication 2, **caractérisé en ce que** l'étage d'entrée comporte :
une première association en série de deux diodes basse tension (32, 33), entre ledit rail haut (Vdd) et la masse, l'anode d'une première diode (33) étant connectée à la masse alors que la cathode d'une seconde diode (32) est connectée au rail haut ; et
une deuxième association en série, entre ledit rail haut et ladite masse, d'au moins deux éléments résistifs (34, 35), les points milieu (31) desdites première et deuxième associations en série étant interconnectés auxdites entrées de lecture (36, 38) desdits premier et second comparateurs (37, 39) .

4. Circuit de détection (25) selon la revendication 2 ou 3, **caractérisé en ce que** lesdites première et seconde tensions de référence sont fixées par au moins un pont diviseur résistif réalisé entre ledit rail haut (Vdd) et la masse (C).

5. Circuit de détection (25) selon la revendication 4, **caractérisé en ce que** lesdites première et seconde tensions de référence sont fixées par un seul pont diviseur résistif constitué par une connexion en série, entre ledit rail haut (Vdd) et ladite masse (C) , de trois éléments résistifs (41, 44, 45), lesdits seuils prédéterminés étant respectivement prélevés aux bornes de la résistance (45) intermédiaire du pont.

6. Circuit de détection (25) selon l'une quelconque des revendications 1 à 5, **caractérisé en ce que** des sorties (COMP1, COMP2) des premier et second comparateurs (37, 39) sont combinées.

7. Circuit de détection (25) selon la revendication 6, **caractérisé en ce que** les sorties (COMP1, COMP2) sont combinées par une porte logique OU (42) à deux entrées.

8. Circuit de détection (25) selon l'une quelconque des revendications 1 à 7, **caractérisé en ce que** l'élément traversé par un courant alternatif d'alimentation est un interrupteur bidirectionnel (22).

9. Circuit de détection (25) selon l'une quelconque des revendications 1 à 7, **caractérisé en ce que** l'élément traversé par un courant alternatif d'alimentation est une résistance (70) .

10. Circuit de protection (24) contre un surcourant d'un interrupteur bidirectionnel (22) à l'état fermé, traversé par un courant alternatif d'alimentation, **caractérisé en ce qu'**il comporte un circuit de détection (25) selon la revendication 8.

11. Circuit de protection (24) contre un surcourant d'un interrupteur bidirectionnel (22) à l'état fermé, traversé par un courant alternatif d'alimentation, **caractérisé en ce qu'**il comporte un circuit de détection (25) selon la revendication 9, ladite résistance étant en série avec ledit interrupteur.
